Europäisches Patentamt

European Patent Office

Office européen des brevets

(11) Veröffentlichungsnummer: **0 331 953 B1**

(12) **EUROPÄISCHE PATENTSCHRIFT**

(45) Veröffentlichungstag der Patentschrift: **23.12.92**

(51) Int. Cl.⁵: **H05K 7/20**

(21) Anmeldenummer: **89102856.5**

(22) Anmeldetag: **18.02.89**

(54) **Leiterplatte mit einer Kühlvorrichtung.**

(30) Priorität: **25.02.88 DE 3805851**

(43) Veröffentlichungstag der Anmeldung:
**13.09.89 Patentblatt 89/37**

(45) Bekanntmachung des Hinweises auf die
Patenterteilung:
**23.12.92 Patentblatt 92/52**

(84) Benannte Vertragsstaaten:
**AT BE CH DE ES FR GB IT LI NL SE**

(56) Entgegenhaltungen:
**EP-A- 0 083 538**
**EP-A- 0 197 817**
**DE-A- 3 329 325**

(73) Patentinhaber: **Alcatel SEL Aktiengesellschaft**
**Lorenzstrasse 10**
**W-7000 Stuttgart 40(DE)**
(84) Benannte Vertragsstaaten:
**DE**

(73) Patentinhaber: **ALCATEL N.V.**
**Strawinskylaan 537 (World Trade Center)**
**NL-1077 XX Amsterdam(NL)**
(84) Benannte Vertragsstaaten:
**BE CH ES FR GB IT LI NL SE AT**

(72) Erfinder: **Seibold, Gerhard**
**Rechbergweg 4**
**W-7148 Remseck 3(DE)**
Erfinder: **Smernos, Stauros, Dr.**
**Birkenwaldstrasse 127**
**W-7000 Stuttgart 1(DE)**
Erfinder: **Florjancic, Matjaz, Dr.**
**Erlenweg 21**
**W-7144 Murr(DE)**
Erfinder: **Thaidigsmann, Otto**
**Rotenbergstrasse 112**
**W-7000 Stuttgart 1(DE)**
Erfinder: **Richter, Horst, Dr.**
**Tiergartenstrasse 29**
**W-7030 Böblingen(DE)**

(74) Vertreter: **Pohl, Herbert, Dipl.-Ing et al**
**Alcatel SEL AG Patent- und Lizenzwesen**
**Postfach 30 09 29**
**W-7000 Stuttgart 30(DE)**

EP 0 331 953 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Leiterplatte mit einer Kühlvorrichtung, die von einem Kühlmedium durchströmte Kanäle aufweist.

Mit der zunehmenden Integrationsdichte von Halbleiterschaltungen nimmt auch die Verlustleistung pro Flächen- oder Volumeneinheit zu. Sie wirksam abgeführt werden, indem sie z.B. über die Anschlußdrähte oder die Kontaktfläche des Bauelements auf die Leiterplatte übertragen und auf dieser verteilt und abgeführt wird. Die Wärmeabfuhr muß so schnell erfolgen, daß sich keine überhitzten Stellen bilden, die im schlimmsten Fall zu einem Ausfall der Halbleiterbauelemente führen können. Bei Leiterplatten, die dicht mit Bauelementen bestückt sind, bei denen also viel Verlustwärme erzeugt wird, reicht eine solche Verteilung und Abfuhr der Wärme nicht mehr aus, sie müssen mit einer zusätzlichen Kühlvorrichtung versehen werden.

Eine bekannte Kühlvorrichtung besteht aus einer hohlen Kupferplatte, die im Innern mit Zwischenwänden versehen ist, die Kühlkanäle bilden (EP 0 083 538 B1). Auf eine oder auf beide Oberflächen der hohlen Kupferplatte ist je eine Leiterplatte aufgeklebt, auf die Halbleiterbauelemente entweder direkt oder über Anschlußdrähte aufgelötet sind.

Zum Herstellen der hohlen Kupferplatte wird ein Modell aus Wachs oder einem anderen niedrigschmelzenden Werkstoff hergestellt, in das die Zwischenwände aus Kupfer eingebettet oder Aussparungen zum Durchstecken der Anschlußdrähte eingearbeitet werden. Das Modell wird dann allseitig galvanotechnisch mit einer Kupferschicht überzogen. Anschließend wird der Kupferüberzug an zwei Stirnflächen mechanisch abgearbeitet. Schließlich wird das Wachs oder dergleichen durch Aufschmelzen entfernt, wonach die frei gewordenen Hohlräume als Kühlkanäle dienen können. Die Herstellung der hohlen Kupferplatten ist also sehr aufwendig und für eine Herstellung in großen Stückzahlen nicht besonders geeignet.

Der Erfindung liegt die Aufgabe zugrunde, eine Leiterplatte zu schaffen, die einfach herzustellen ist und die, auch wenn sie sehr dicht mit Bauelementen bepackt ist, die Wärme wirksam abführt.

Diese Aufgabe wird erfindungsgemäß durch eine Leiterplatte gelöst,
- die aus mindestens drei miteinander verbundenen Schichten aufgebaut ist, und
- bei der die Kanäle durch Aussparungen in einer innenliegenden Schicht gebildet sind.

Zweckmäßigerweise können die die Leiterplatte bildenden Schichten miteinander verklebt sein oder unter Verwendung von Klebefolien miteinander verbunden sein. Sie werden dann unter Einwirkung von Druck und/oder Temperatur dauerhaft miteinander verbunden.

Aus der Tatsache, daß die Kühlvorrichtung nach der Erfindung Bestandteil der Leiterplatte selbst ist, ergeben sich eine ganze Reihe von Vorteilen. Die Kühlkanäle können ohne weiteres so geführt werden, daß sie direkt unter den Halbleiterbauelementen verlaufen. Damit kann die Wärme direkt und wirksam an der Stelle, an der sie erzeugt wird, abgeführt werden. Die Leiterplatte behält ihre Abmessungen bei, zusätzlicher Platz für eine Kühlvorrichtung wird nicht benötigt. Die Leiterplatte kann auch ohne weiteres mit Durchkontaktierungen zur Aufnahme von bedrahteten Bauelementen versehen werden. Die zum Herstellen der erfindungsgemäßen Leiterplatte benötigten Werkstoffe - z.B. glasfaserverstärkte Epoxidharze des Typs FR4 - und Vorrichtungen - z.B. Heißpressen - werden für die Herstellung sogenannter Multilayer-Leiterplatten ohnehin benötigt. Die Herstellung der erfindungsgemäßen gekühlten Leiterplatten erfordert somit keinerlei zusätzliche Werkstoffe oder Einrichtungen. Die Kühlkanäle können durch einfaches Fräsen, Stanzen oder Schneiden der innenliegenden Schicht der Leiterplatte vorbereitet werden.

Ein Ausführungsbeispiel der Erfindung wird im folgenden anhand der Zeichnung erläutert. Es zeigen:

Fig. 1    eine erfindungsgemäße Leiterplatte im Querschnitt und

Fig. 2    die Leiterplatte nach Fig. 1 in der Draufsicht.

Auf der Leiterplatte, von der nur ein Ausschnitt dargestellt ist, ist ein Halbleiter-Bauelement 1 befestigt. Die Leiterplatte selbst besteht aus zwei äußeren Schichten oder Abdeckschichten 2, auf denen Leiterbahnen 3 aus Kupfer angebracht sind, und aus einer inneren Schicht oder Abstandsschicht 4.

Aus der inneren Schicht 4 sind Schlitze oder Ausnehmungen ausgefräst, ausgestanzt oder ausgeschnitten, die in Verbindung mit den beiden äußeren Schichten 2 Kanäle 5 bilden, die von einem Kühlmedium, z.B. einer Kühlflüssigkeit, durchströmt werden, das die Verlustwärme wirksam abführt.

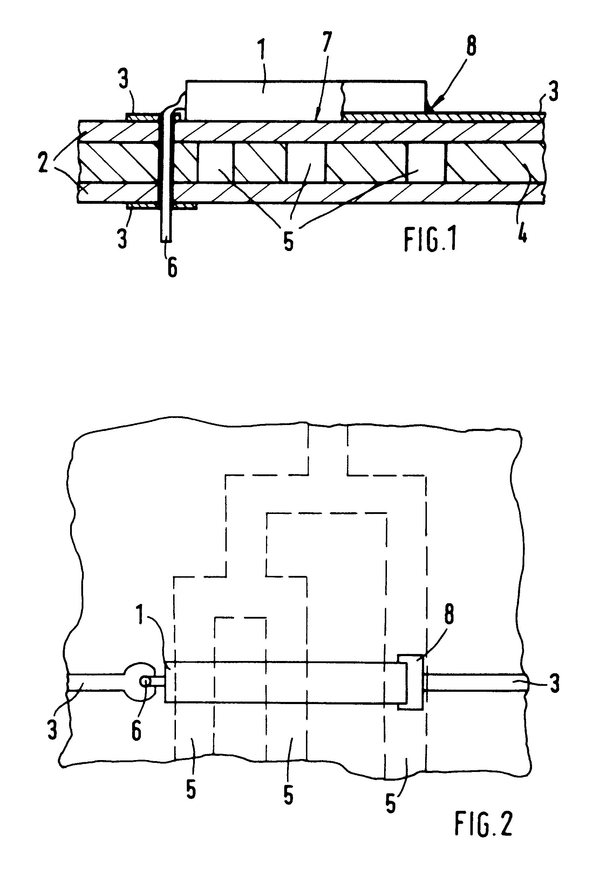

In der Draufsicht (Fig. 2) sind die Kanäle 5 gestrichelt dargestellt. Sie können je nach den thermischen und konstruktiven Gegebenheiten der Leiterplatte einzeln (vergleiche rechts) oder gebündelt (vergleiche links) geführt werden.

Das Bauelement 1 ist auf seiner linken Seite mit Anschlußdrähten 6 versehen, die durch die Leiterplatte hindurchgesteckt und mit ihr verlötet sind. Das Bauelement 1 liegt mit einer großen Kontaktfläche 7 auf der äußeren Schicht 2 auf, so daß ein einwandfreier Wärmedurchgang gesichert ist.

Auf der rechten Seite von Fig. 1 ist das Bauelement 1 als oberflächenmontiertes Bauelement dargestellt, das über einen unbedrahteten Anschluß 8 mit der Leiterplatte 3 verbunden ist. Beide Anschlußarten sind hier nur zur Verdeutlichung an einem Bauelement dargestellt, normalerweise wird ein Bauelement entweder mit oder ohne Anschlußdrähten an die Leiterbahnen der Leiterplatte angeschlossen sein.

Die äußerden Schichten 2 und die innere Schicht 4 können durch Kleben miteinander verbunden werden, wobei die Klebschicht erforderlichenfalls unter Hitzeeinwirkung beschleunigt ausgehärtet werden kann. Die Schichten 2 und 4, oder zumindestens zwei von ihnen, können auch mittels eines Prepreg verbunden werden. Ein Prepreg ist eine glasfaserverstärkte Klebefolie aus einem anpolymerisierten Kunstharz. Das Kunstharz aus einem Polyester oder Epoxid wird durch Heißpressen auspolymerisiert und verfestigt und ergibt dann eine einwandfreie Verbindung der einzelnen Schichten.

**Patentansprüche**

1.  Leiterplatte mit einer Kühlvorrichtung, die von einem Kühlmedium durchströmte Kanäle aufweist,
    **dadurch gekennzeichnet,**
    - daß die Leiterplatte aus mindestens drei miteinander verbundenen Schichten (2, 4) aufgebaut ist, und
    - daß die Kanäle (5) durch Aussparungen in einer innenliegenden Schicht (4) der leiterplatte gebildet sind.

2.  Leiterplatte nach Anspruch 1, dadurch gekennzeichnet daß die Schichten (2, 4) miteinander verklebt sind.

3.  Leiterplatte nach Anspruch 1, dadurch gekennzeichnet, daß die Schichten (2, 4) unter Verwendung von Klebefolien miteinander verbunden sind.

**Claims**

1.  Circuit board with a cooling device having channels through which a cooling agent flows,
    **characterized in**
    - that the circuit board is composed of at least three united Layers (2, 4), and
    - that the channels (5) are constituted by slots or recesses in an inner layer (4) of the circuit board.

2.  A circuit board as claimed in claim 1, characterized in that the layers (2, 4) are united by an adhesive.

3.  A circuit board as claimed in claim 1, characterized in that the layers (2, 4) are united by means of adhesive films.

**Revendications**

1.  Carte à circuit imprimé avec un dispositif de refroidissement qui présente des canaux parcourus par un fluide refroidisseur,
    caractérisée
    - par le fait que la carte à circuit imprimé est composée d'au moins trois couches (2, 4) liées l'une à l'autre, et
    - par le fait que les canaux (5) sont formés par évidements dans une couche intérieure (4) de la carte à circuit imprimé.

2.  Carte à circuit imprimé selon la revendication 1, caractérisée par le fait que les couches (2, 4) sont collées l'une avec l'autre.

3.  Carte à circuit imprimé selon la revendication 1, caractérisée par le fait que les couches (2, 4) sont liées l'une à l'autre par emploi de feuilles encollées.

FIG.1

FIG.2